Europäisches Patentamt

European Patent Office

Office européen des brevets

(19)

(11) **EP 0 322 419 B1**

(12) **EUROPEAN PATENT SPECIFICATION**

(45) Date of publication and mention
of the grant of the patent:
**30.10.1996 Bulletin 1996/44**

(21) Application number: **87906273.5**

(22) Date of filing: **09.09.1987**

(51) Int Cl.6: **G01N 23/00**, G03G 13/00,
G03G 15/00, G21K 7/00

(86) International application number:
**PCT/US87/02310**

(87) International publication number:
**WO 88/02110 (24.03.1988 Gazette 1988/07)**

(54) **POINT PROJECTION PHOTOELECTRON MICROSCOPE WITH HOLLOW NEEDLE**

PUNKTPROJEKTIONS-PHOTOELEKTRONENMIKROSKOP MIT HOHLNADEL

MICROSCOPE PHOTOELECTRONIQUE A PROJECTION PONCTUELLE ET AIGUILLE CREUSE

(84) Designated Contracting States:
**AT BE CH DE FR GB IT LI LU NL SE**

(30) Priority: **11.09.1986 US 906354**

(43) Date of publication of application:
**05.07.1989 Bulletin 1989/27**

(73) Proprietor: **HIRSCH, Gregory**
**Pacifica, CA 94044 (US)**

(72) Inventor: **HIRSCH, Gregory**
**Pacifica, CA 94044 (US)**

(74) Representative: **Patentanwälte**
**Dipl.-Ing. R. Splanemann Dr. B. Reitzner**
**Dipl.-Ing. K. Baronetzky**
**Tal 13**
**80331 München (DE)**

(56) References cited:
US-A- 3 796 901    US-A- 3 805 068
US-A- 3 869 308    US-A- 4 087 683
US-A- 4 096 386

- **REV. SCI. INSTRUM., vol. 52, no. 2, February
  1981, pages 207-212, American Institute of
  Physics; F. POLACK et al.: "Photoelectron
  microscope for x-ray microscopy and
  microanalysis"**
- **NUCLEAR INSTRUMENTS AND METHODS, vol.
  208, 1983, pages 373-377, North-Holland; F.
  POLACK et al.: "Project of a photoelectron x-ray
  microscope on ACO storage ring"**
- **J. APPL. PHYS., vol. 44, no. 11 November 1973,
  pages 5155-5159, American Institute of Physics;
  W.R. GRAHAM et al.: "Field ion microscope
  images of DNA and other organic molecules"**

## Description

The present invention relates to microscopes. More particularly, the invention relates to microscopes which generate images by passing x-rays or other electromagnetic radiation through a sample.

Contact microscopy is known. Typically, according to "nuclear instruments and methods" Vol. 208, 1983, pages 373 to 377, x-rays are directed onto a sample placed on an x-ray sensitive medium. the x-rays may be continuous or pulsed with nanosecond duration and high intensity and are recorded on the medium. Thereafter, the medium is developed and the x-ray shadow image is examined with an electron microscope. Excellent image contrast results. See Synchrontron Radiation published by Plenum Press of New York, N.Y. 1980, pp. 277-322.

No continuous imaging for observing specimens in vivo is usually possible. A single picture of the specimen is all that is provided. Stereoscopic imaging with depth information is also not easily obtained as specimen must be lifted off medium and redeposited on new medium for multiple exposures.

It is also known to construct a photoelectron x-ray microscope on a flat surface. X-rays bombard the flat surface through a sample and thereafter liberate electrons from a semitransparent photocathode. This contact method of producing an electron image requires electron optics to image the electrons. These optics are expensive and complex.

Point source x-ray projection microscopes are known. A point source of x-rays projects an enlarged shadow of a sample onto a distant image plane. This method has limitations in that image resolution is lost due to finite x-ray source size-a point source is never truly produced. Further there is a need to have the object very close to the x-ray source, which is a practical limitation.

Field ion and field emission microscopy is known. The sample is the tip of a very sharp needle. A high electric field is generated at the needle point causing electrons or ions to flow radially from the needle to a distant screen producing an enlarged image. High magnification with 2 to 3 Å resolution in the ion case results. See Field Ion Microscopy published by AMERICAN ELSEVIER 1969. Unfortunately using this technique, there has been little success in examining biological samples placed on the surface of the needle. Images of atomic structure on the exterior surface of the needle can only be produced. Since the needle must be exposed to a vacuum, in vivo examination of the specimen is again not possible even if the other problems were solvable.

Scanning x-ray microscopes are known. In such technique a collimated x-ray beam is scanned in a raster pattern. An image is created by mapping the point to point intensity of the transmitted beam. Unfortunately, in this technique, the limitations include the size of the beam that one is able to produce. Consequently, the resolution of the image is limited to the beam diameter.

Microscopes using focusing elements for x-rays are known. These use grazing incidence optics or zone plate focusing techniques on the x-rays. Unfortunately in such microscopes, the x-rays are poorly focused by presently available optics.

Electron microscopes are known. In such microscopes samples are cut to extremely thin sections. Unfortunately, the contrast of such thin section material when bombarded by electrons is not good. Therefore, stains are frequently required in use. Moreover, the sample is placed in a vacuum chamber for observation. Therefore, in vivo observation of the sample is not possible.

## SUMMARY OF THE INVENTION

A point projection photoelectron microscope is disclosed. A specimen is enclosed in a photoconductor that is subject to the photoelectric effect. The specimen is bombarded by radiation, either of light, ultraviolet radiation, or soft x-rays. The photoconductor is in a vacuum chamber and it is highly charged with a negative potential. The vacuum chamber includes a surface sensitive to electron flow for making an image. This surface is a phosphor screen or an image intensifier having the capability to be gated for imaging or not imaging incident electrons or a segmented electron collecting anode for electronic imaging. In operation, a collimated beam of radiation, ranging from light to soft x-rays is projected through a specimen disposed in the photoconductor. An image of the specimen is produced on the photoconductor. The light or x-ray which impact on the photoconductor which produce electrons by the photoelectric effect. The electrons migrate beyond the photoconductor where the electric field at the tip of the photoconductor radially repels the electrons to and towards the imaging surface, typically the image intensifier. The irradiating source (light or soft x-ray) can be pulsed and the image intensifier time gated with respect to the pulse so that electrons having a relatively slow initial velocity, which implies little transverse momentum, are used for the production of the image. There results an image having high magnification which produces high resolution of a sample in vivo. It will be noted the magnification is approximately the distance from tip of a needle to the screen divided by the radius of the needle tip. Resolution in order of 100 Å are possible. It is important to note that magnification is produced without the use of a lens.

## Other Objects and Advantages

An object of this invention is to disclose a photoelectric effect microscope for producing an electron image of a sample placed on the inside of a hollow needle. The hollow needle is constructed of material sufficient to produce from irradiation (selected to range from optical wavelengths to soft x-ray wavelengths) electrons via the photoelectric effect. The needle is communicated to atmosphere on the interior and to a vacuum on the exterior and electrified negatively. Collimated radiation bombarding a sample on the inside of the needle, produces a contact image on the end of a needle, which contact image produces electrons. The electrons are accelerated by the electric field radially away from their point of image on the end of the needle to an image plane.

An advantage of this invention is that it can use either optical wavelengths or soft x-ray wavelengths. Superior contrast can be produced.

A further advantage of the disclosed technique is that the image produced at the end of the needle is essentially a contact image. Problems of focusing are held to a minimum.

Yet another advantage of this invention is that the magnification required is produced by the radial acceleration of the electrons. The needle for its own part provides the necessary optical element when electrified. Extensive electron optics, grazing incidence optics and refractive or reflective optics are all avoided.

A further advantage of the optic and x-ray irradiation is that these can be tuned to the particular element that an observer wishes to view from a sample. For example, by selecting soft x-ray radiation just above an absorption edge-say the absorption edge for carbon in a sample-the carbon will be emphasized in the image of the sample.

Yet an additional advantage is that the x-rays can be continuously pulsed in recording movement of a sample in vivo. Sequential observations of a specimen are possible before significant damage to the specimen occurs due to the effects of the incident radiation.

Yet another advantage of this invention is that the sample is placed near an extremely high electric field environment. Since, however, the conducting needle in effect surrounds the sample, the sample is not effected by the field. The electron image, however, is produced as a direct result of electrons accelerating away in the surrounding electric field. Due to the strength of the field, an image nearly free of chromatic aberration can be produced. Also, due to the high electric field, space charge effects are minimized.

Yet another advantage of the disclosed technique is that stereo images are possible. Simply stated, by impacting the sample at the end of the needle with collimated rays of varying angularity, stereo images can be projected. Thus, three dimensional information is available utilizing the technique of this invention.

A further advantage is that the x-rays can be adjusted in intensity. They can be held and pulsed at a level where destruction of life or structure within the specimen is delayed. Although the resolution will suffer at lower intensities, this delay can in effect enable the specimen to be observed in vivo. This in vivo observation can occur before any substantial effect on the specimen occurs due to radiation damage. Alternately, one can use a very intense short burst of radiation which will give a very high resolution image. This high resolution image is due to the fact that the specimen remains intact long enough for the image to be recorded before the specimen disintegrates.

A further object of this invention is to disclose an apparatus and method for the focus of the produced electron image. According to this aspect, the sample on the inside of the beam receives pulsed bursts of radiation. The pulsed bursts of radiation produce electrons having variant amounts of momentum as they leave the photocathode on the end of the needle to the area of high electric field. The electrons are radially accelerated in the vacuum chamber to an image collection point, preferably a gated image intensifier. By having the image intensifier gated at precise time intervals with respect to the interrogating pulsed radiation, electrons having little initial momentum so as to produce only radial acceleration and a sharp image are received at the intensifier. All other electrons possessing larger momentums will arrive in a time domain which is outside of the gating of the intensifier. Thus, by the expedient of gating the intensifier relative to the pulsed image, high focus can be achieved.

A technique of photoetching of the needle for containment of the sample is disclosed. As a first step, a male needle member is produced by a photoetching technique known in the prior art. This male needle is thereafter coated with a material capable of producing photoelectrons when bombarded by interrogating radiation. Thereafter, the male needle member is etched away leaving the hollow needle which can receive samples, is disposable, and forms the electron optics of this invention.

Other objects, features and advantages of this invention will be more apparent after referring to the following specification and attached drawings in which:

BRIEF DESCRIPTION OF THE DRAWINGS

Fig. 1 is a schematic view of the x-ray microscope of this invention illustrating the needle confronted to a vacuum chamber illustrating in broken lines the path of radially accelerated electrons to an imaging surface;

Fig. 2 is a schematic cross section of an image intensifier having gating for discriminating out imaging electrons having a preferred velocity profile;

Figs. 3A, 3B, 3C and 3D are examples of a prior art technique for fabricating a male needle;

Figs. 4A, 4B, 4C and 4D illustrate sequentially the fabrication of the female and hollow needle, the placement of a sample within the needle, the irradiation of the needle to produce the desired image, and an overall view of a needle in section.

Fig. 5 is a drawing of a first alternative embodiment.

Fig. 6 is a drawing of a second alternative embodiment.

## DETAILED DESCRIPTION OF THE PREFERRED EMBODIMENTS

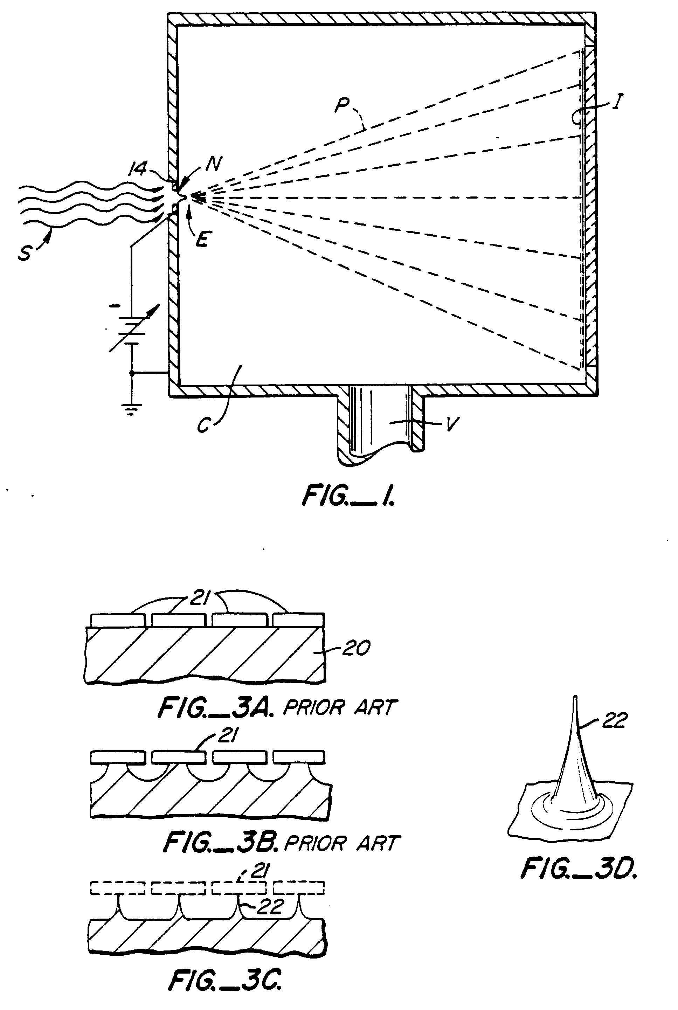

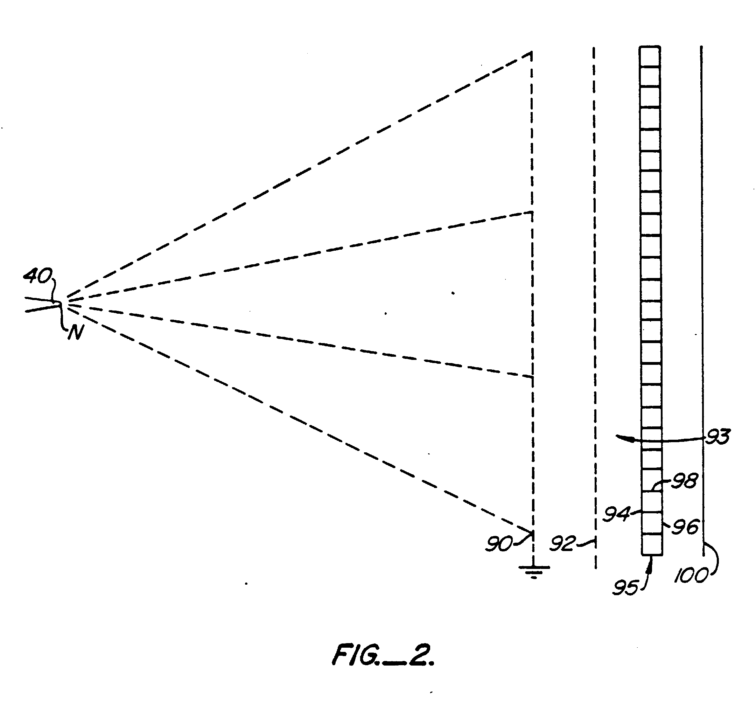

Referring to Fig. 1, a vacuum chamber C has a needle N mounted to an opening 14. The needle is hollow, has its inside exposed to atmosphere exterior of chamber C and its outside exposed to the interior of the chamber C. A vacuum is drawn on the chamber in the range of pressure less than or equal to $10^{-6}$ torr through pumping line V. Thereafter, a radiation source S irradiates the inside of the needle producing in the needle material electrons by the photoelectric effect.

The reader will understand that minimum vacuum is required to permit electron flow. Generally a vacuum of at least $10^{-2}$ torr must be drawn. Higher vacuum is desired to minimize sputtering damage to needle.

The end of the needle N creates a high electric field when charged. The high negative electric field causes electrons produced by the photoelectric effect to undergo rapid, radial acceleration. The produced electrons generally follow a path P to an image surface I. Image surface I can be a phosphor screen, an image intensifier capable of being gated or a segmented electron collecting anode for electronic imaging. At the image plane I, the contact image of the sample on the material at the point of the needle is produced. A magnified overall image results.

I would like to point out that a contact image is also a special example of an extreme near field Gabor hologram. See Synchrontron Radiation Research reference, Sec. 3.1.3, page 293 published by Plenum Press. Therefore, this invention may be useful for holography in addition to the simple contact shadowgraph image. Holography has the important advantage of not having the resolution fall off as the specimen detail to photocathode distance is increased. In the x-ray wavelength band, this could give less than 100 Å resolution throughout a fixed specimen in vivo.

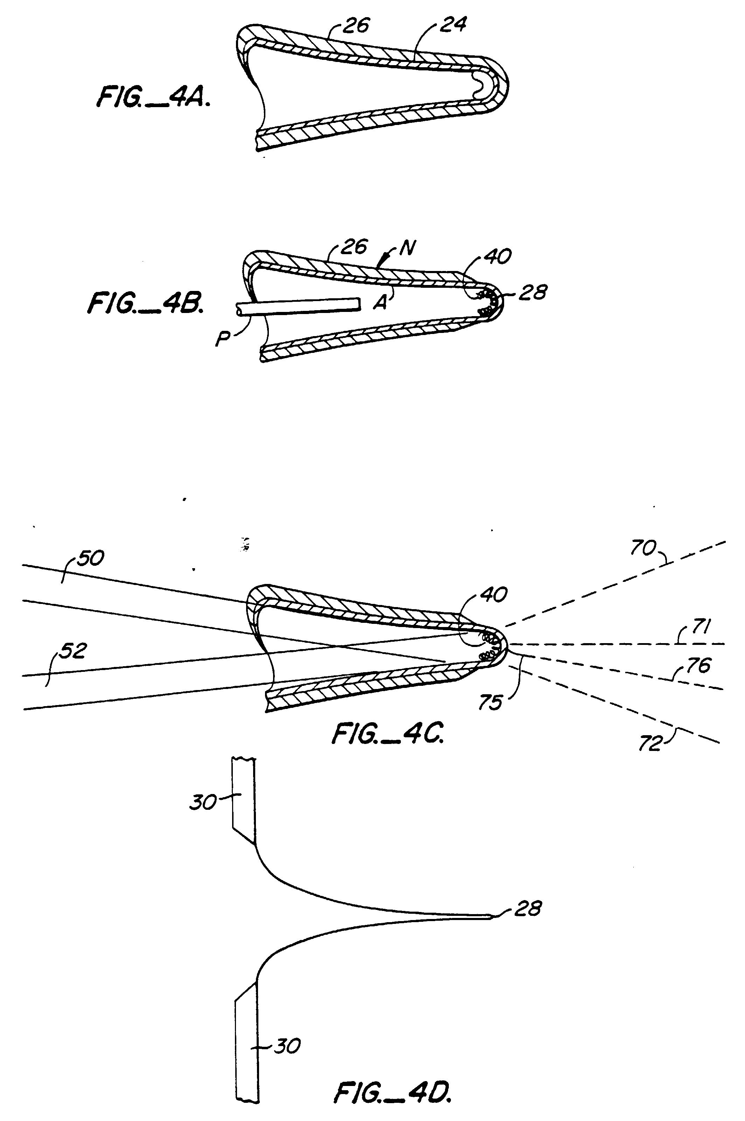

Having summarized this invention, the detailed parameters will now be set forth. First, and with respect to Figs. 3A-D and 4A-C, the construction of the needle, placement of the sample and imaging of the sample will be discussed. Secondly, the operating parameters of the microscope will be set forth.

Referring to Fig. 3A, a technique is illustrated for needle fabrication. Originally, this technique was designed for fabrication of large area field emission arrays. See article entitled Etching Procedure Fabrication of Large Area Field Emission Arrays by R.N. Thomas, R. A. Wickstrom, D.K. Schroder and H.C. Nathanon, Westinghouse Research Laboratories, Pittsburg, Pennsylvania published in Solid State Electronics 1974, Vol. 17 pp 155-163, printed by the Pergamon Press of Great Britain. In this article, it is disclosed that an etchable substrate 20 is covered with etched maskings 21 in a circular format. When exposed to etching materials, the etchant undercuts the masking 21 as illustrated in Fig. 3B to a needle format as illustrated in Fig. 3C. A needle 22 results.

Needle 22 can be controlled as to the radius of curvature and diameter at the needle end by various techniques mentioned in the article. As the needle in Fig. 3D was utilized for large area field emission arrays, the further processing illustrated with respect to Figs. 4A-4C, comprises my invention and has no connection with the prior art. In short, the prior art does not disclose my concept of making the needle hollow. There are other ways to produce similar structures but this appears to be the most convenient.

Referring to Fig. 4A, needle 22 has been coated with a thin material 24 and a thicker reinforcing material 26 and the original needle 22 etched completely away leaving only the coatings 24 and 26. Coating 24 is a material subject to the photoelectric effect.

Referring to Fig. 4B, the needle is illustrated having a protective and reinforcing coating 26 deposited over the coating. This material serves to reinforce the needle against the physical pressure forces of the atmosphere on one side, to and towards the evacuated portion of the chamber on the other side. As can be seen, coating 26 stops adjacent the point of the needle at 28. This can be accomplished by a masking and etching step.

The reader should appreciate that it is not necessary for the photocathode to have a radius of curvature equivalent to twice its diameter (in other words to be a hemisphere). Even a flat photocathode forming the tip closure of a hollow needle (basically a truncated needle) will form a radially projective electron image. The image will have some distortion which may be acceptable. By simply undercutting the mask 21 and stopping at a desired tip diameter before undercutting is complete, one will form a flat photocathode after coating and etching out of the needle 22. Forming a radius of curvature on tip can be accomplished by chemical etching or thermal blunting of the needle 22 before it is coated and etched out.

Stopping here the specific mechanics of the needle and its desired properties can be discussed. The thickness of the coating is small. A 1,000 Å thickness of a material subject to the photoelectric field at 28 will be sufficient. The coating should be thick enough to stop the radiation but not so thick as to not transmit the photoelectrons. In other words, it is a semitransparent type photocathode. Reinforcing layer 26 is typically constructed of a metal film several microns thick. Dielectric, semiconductor, or polymer films are also possible. Regarding the material of coating 24, any material subject to the photoelectric effect will suffice. Gold, for example, is a desirable substance. Special low work function coatings are necessary to work in the optical wavelengths. Photocathodes incorporating non-metals such as cesium iodide are also useful due to their high quantum yield and low average photoelectron energy.

The area of the end of the needle is small. Therefore an extremely thin coating will suffice as the required barrier against the atmospheric and electrostatic force at the end of the needle. The elctrostatic force is in fact equivalent to over ten atmospheres under standard operating conditions.

I prefer iridium for the coating 24 from which the needle is made. This is because iridium is very inert to most chemicals, has high strength and should be optimally employable in the disposable needle set forth. Other hard noble metals are possible.

The needle is provided with a flange 30. (See Fig. 4D.) Flange 30 is the surface upon which the needle rests in aperture 14 in the vacuum chamber C. This flange 30 is left over substrate which was masked so as to not be etched away.

The reader will note that the needle is extremely small. For instance, a needle point radius of the order of 1-5 microns is typical.

Having discussed the fabrication of the needle and continuing at Fig. 4B, the placement of the sample and the irradiation of the sample may now be set forth.

Referring further to Fig. 4B, a pipette P of the drawn glass fiber type is illustrated. The pipette deposits a sample 40 at the inside of the needle structure N. It is this sample 40 which when irradiated by interrogating radiation produces a contact image on the material 28 of the needle.

Referring to Fig. 4C, collimated radiation 50 impinges upon the sample 40 immediately overlying the material 28 at the curved portion of the needle. The radiation is either optical or soft x-ray. For the purposes of this example, a soft x-ray image will be considered.

The material of the sample 40 attenuates the soft x-ray. It produces at the tip of the needle an essentially contact image. The contact image is produced by the x-rays in the material subject to the photoelectric effect and therefore produces electrons. The electrons produced are proportional in intensity to the transmitted image of the irradiated specimen.

The reader will understand that a contact image of the sample 40 is in effect produced. That is to say, the sample has a very small spatial depth overlying the end point of the needle. This small spatial depth minimizes penumberal blurring of the image. That is to say, the radiation produced image does not have the shadow of its details blurred because of the appearance of the radiation coming from a source having a discrete radiating diameter. The main source of blurring will be due to diffraction.

As also shown in Fig. 4C, it is possible to irradiated the sample 40 from two angles with respect to the needle. In Fig. 4C two beams of radiation 50, 52 are illustrated. These are preferably alternately irradiated on the target to produce alternate, sequential, and closely temporally spaced images. Separate images may be recorded on separate cameras using fast electro-optic shutters to avoid image superposition. Naturally, a fast decay phosphor is necessary on the imaging screen to avoid a persistent image from the first image being superimposed on the second. Alternatively a segmented anode with fast electronics can record the multiple exposures.

I prefer to pulse the radiation from source S shown in Fig. 1. It is possible when pulsing the image from source S to avoid blurring of electron image. In order that this aspect of the invention may be understood, I include herewith first an explanation of the source of the blurring and thereafter, the preferred use of an image intensifier to gate the receipt of the image with respect to the pulse to improve focus.

Referring to Fig. 4C, it will be appreciated that electrons created by the photoelectric effect be accelerated away from the point 28.

The electrons will radially accelerate away from the needle point along path lines 70, 71, and 72. Presuming the path of the electrons is radial, the electrons will carry information about a contact image at the end point of the needle.

Unfortunately, electrons produced by the photoelectric effect do not have the same velocity and direction from their point of production. Some electrons are fast and initially travel in a direction which is other than radial, due to a transverse component of initial momentum when originally liberated by the photoelectric effect. Other electrons are slow. In either event, the produced image can become blurred. This spread in energy can be minimized with a coating of a material such as cesium iodide.

I have illustrated the non-radial path of such a fast electron at 75. The electron path 75 is that of a relatively fast moving electron moving out at an angle which is other than radial with respect to the point of the needle 28. The electrons initial momentum causes its trajectory to occur along the path 76.

The reader will remember that the image produced at the end point of the needle 28 is a contact image. Being a contact image, if an electron moving along the path 76 is allowed to impinge at the image plane I, an undesirable blurring of the image can occur.

Fortunately, an image intensifier I imparts the ability to gate or select the time interval of electrons received at the image intensifier I. Naturally, I gate the time interval to receive the radially moving electrons along the paths 70, 71, 72 and discriminate out shorter time interval electrons such as that illustrated in path 75 from producing an image I.

Referring to Fig. 2, I illustrate a specimen 40 within a needle N. Collimated radiation 50 impinges upon sample 40, and thereafter produces electrons in needle N having the image information. The local electric field about the point of the needle produces all the acceleration to the produced electrons -- they are radially accelerated away.

The electrons are accelerated by the negative potential of the needle. The needle thus produces the only force of acceleration; image information is preserved.

It will be understood that the photoelectric effect produces electrons having varying velocities. For example, the velocities of electrons leaving the needle can vary in the range of 30 EV. It will be further understood that moving electrons can have velocity vectors that degrade the image information acquired at the sample. Therefore, it is preferred to have electrons ultimately imaged which have as little as possible relative velocity with respect to the sample when the electrons are originally generated by the photoelectric effect.

Thus, when the acceleration from the electric potential at the end of the needle occurs, the velocity attained will be due to the acceleration force provided by the potential of the negative field at the end of the needle and residual '(and undesired) velocity from the producing photoelectric effect itself.

Some exemplary voltages will help. Assuming the tip of the needle is at a voltage of -10,000 volts, electrons will be accelerated away from the needle and reach energies of 10,000 to 10,030 EV.

No forces of acceleration other than that provided by the needle should be provided to the electrons until they reach the area where imaging will occur. This being the case, the electrons will see a grounded screen 90. This screen has the effect of shielding the electrons from any extraneous forces that will either degrade the image information or effect the desired radial acceleration that produces the desired magnification.

At this juncture, it will be seen that the electrons having low energy (about 10,000 EV) are desired; the electrons having higher energy (about 10,030 EV) are not desired. The remainder of the illustrated imaging circuitry effects this discrimination.

Specifically, a second retarding potential screen 92 is provided. This screen has a negative voltage slightly less than the needle voltage in the order of -9,990 volts for the given example. Thus, the electrons will be decelerated by the screen to energies in the range of 10 EV to 40 EV for the illustrative voltages used here.

After passage through the screen 92 with resultant deceleration, the electrons will enter drift area 93 between screen 92 and a microchannel image intensifier plate 95. Plate 95 includes a front surface 94, a series of conventional microchannels for electron avalanche image intensifying and a rear surface 96 which can have its potential made less negative than front surface 94 for promoting the electron avalanche.

It will be appreciated that the electrons in the drift area 93 will be temporally classified according to energy with the fast (and undesired) electrons traversing drift space 93 first and the slower (and more desired) electrons traversing the drift space 93 second. This being the case, surface 96 is maintained at the same potential as surface 94 to avoid image intensification of fast electrons during their time period of arrival at surface 96. Thus, during this time period surface 96 will be maintained at -9,990 volts, the same voltage as decelerating screen 92 and surface 94.

When the slow moving electrons reach surface 94-- having 10 EV-the rear surface 96 is switched by conventional circuitry to a voltage closer to ground -9000 volts in the example given. Therefore, multiplication of the electrons in the microchannel plates will occur which have the slower velocity only.

Thereafter, the imaging is conventional. Microchannel plate then produces the intensified electron image. Phosphor screen 100, at a potential closer to ground produces the image.

The reader will realize that the image intensifier I can be replaced by a phosphor screen for the regular imaging of the electrons. In addition, one can use a simple phosphor screen and do time domain selection of the electrons which contribute to the image by the camera recording device with a fast electro-optic shutter. A very short persistence phosphor will then be required. A segmented anode is also usable for electronic imaging where the electrons arrival is recorded spatially by monitoring current.

The proceeding electron energy discrimination scheme requires the use of a pulsed radiation source and precise timing and switching electronics. One can operate this retarding potential energy discrimination arrangement in a different manner and use a continuous source of radiation. The higher energy electrons can be imaged by simply using the retarding potential to stop and repel the lower energy electrons. These electrons are not well imaged for high resolution; however, if one makes two different exposures, the desired result can be obtained. Specifically, one exposure is made without any retarding potential so that all the electrons are imaged. Next a retarding potential is used which is high enough to actually stop and repel the desired low energy electrons and a second exposure is made. To produce an image of the specimen utilizing just the low energy electrons, the difference in the two images is produced by subtracting the second image from the first. The difference between the two is simply the contribution of the low energy electrons. This subtraction can be done conveniently by computer image processing.

More sophisticated retarding potential energy discrimination schemes are known in the literature. The previous schemes are used as an example.

The imaging surface and screens associated with the imaging surface should be curved to keep the electric fields parallel to the electron trajectories, although they are shown flat in Fig. 2.

It will be understood where soft x-rays are utilized, a sharp image with under 100 Å resolution can be produced. Diffraction effects are limited due to the reduced wavelength. The degradation due to diffraction effects is reduced with respect to the optical wavelength light.

RESOLUTION

$$\simeq \lambda * \sqrt{D/\lambda}$$

$\lambda =$    wavelength

D =    distance from specimen detail to photocathode

For samples very close to photocathode, high resolution imaging is possible even with optical wavelengths (see references to "near field imaging"). These describe resolution of $\sim\lambda/20$.

It will be appreciated that I prefer to use pulsed x-rays. Continuous x-rays are not sufficiently intense to produce a high resolution image before radiation damage causes image degradation. Pulsed x-ray sources freeze the image so as to give an image of the specimen before radiation induced movement destroys the specimen. In other words, the specimen remains intact for the exposure time, even though it will be completely destroyed less than a millisecond later (pulse duration $\sim$10-100 nanosecond).

It is sufficient if the needle is irradiated by electromagnetic energy sufficient to generate the required photoelectric effect. Wavelengths between 3,000 Å and 1 Å are sufficient for the practice of this invention. By using soft x-rays with a wavelength between approximately 24 and 44 Å, high contrast in hydrated biological specimens can be obtained. This is because water is relatively transparent compared to carbon in this range. By utilizing special coatings (which cannot be exposed to air) wavelength can be extended to $\sim$6000 Å.

These coatings can be deposited in the microscope after pump down or the needle can have a protective cap which keeps the surface in an inert atmosphere when it is exposed to air. The reason to go to these long wavelengths is to completely avoid radiation damage. The resolution will of course suffer, although details right adjacent to the photocathode surface may be very well resolved as they are imaged in the near field regimen.

**Claims**

1. Microscope having a source of radiation, said radiation acting on a sample provided on a support, with said radiation being attenuated with a contact image of said sample, said support comprises a hollow needle having an opening adjacent one end, a closure adjacent to the other end and made from a material which produces a photoelectron response to incident radiation, said hollow needle comprising an inside, adjacent to the closure, for receiving said sample; a chamber for receiving the needle at one portion and for receiving and/or recording an electron image at a second portion, with a vacuum pump allowing a vacuum to be drawn within said chamber; means for applying a negative charge to the needle are provided for causing electrons to move from the needle to the second portion; said radiation attenuated by said sample impacts the closed end of the needle to produce photoelectrons which are radially accelerated away from said needle to produce an electron image of said sample at the tip of said needle magnified by said radial acceleration; and means for receiving and/or recording an electron image from said photoelectrons.

2. Microscope according to claim 1, characterized in that said source of radiation provides pulsed radiation.

3. Microscope according to claim 1 or 2, characterized in that said radiation source provides either soft x-rays, preferably immediately above an absorption edge of atoms in said sample, or said radiation source provides optical wave length radiation.

4. Microscope according to one of the preceding claims, characterized in that said second portion of the chamber includes an image intensifier.

5. Microscope according to one of the preceding claims, characterized in that the vacuum is in the range of $10^{-2}$ to $10^{-6}$ torr.

6. Microscope according to one of the preceding claims, characterized by using a living sample.

7. Microscope according to one of the preceding claims, characterized in that said needle comprises a thin coating (24) made of Iridium.

8. Support for a sample which is intended to be introduced into a microscope having a wall of chamber for receiving and/or recording an electron image, said support being for producing photoelectrons depending on radiation attenuated by said sample and impacting on said support, characterized in that said support is a hollow needle having an opening adjacent one end and a closure adjacent the other end, said closure made from materials which produce photoelectrons responsive to Lzcidemi radiation, and that said closure of the needle defines a site for receiving the sample on the inside of the needle adjacent the closure whereby radiation impacting said sample on the inside of the needle produces a contact electron image of said sample and projects said image to the wall of the chamber.

9. Support according to claim 8, characterized in that said needle has a needle point radius of the order of 1-5 microns.

10. Support according to claim 8 or 9, characterized in that said needle has a protective and reinforcing coating (26) made from materials sufficient to protect said needle from atmospheric pressure.

**Patentansprüche**

1. Mikroskop, das eine Strahlungsquelle aufweist, wobei die Strahlung auf eine auf einer Abstützung vorgesehene Probe wirkt, wobei die Strahlung mit einem Kontaktbild der Probe gedämpft wird, die Abstützung eine hohle Nadel aufweist, die angrenzend an ein Ende eine Öffnung, angrenzend an das andere Ende einen Verschluß aufweist und aus einem Material hergestellt ist, das auf einfallende Strahlung ein Ansprechen eines Photoelektrons erzeugt, wobei die hohle Nadel angrenzend an den Verschluß eine Innenseite zum Aufnehmen der Probe aufweist; wobei eine Kammer zum Aufnehmen der Nadel an einem Abschnitt und zum Empfangen und/oder Aufnehmen eines Elektronenbildes an einem zweiten Abschnitt, mit einer Vakuumpumpe, die es ermöglicht, daß ein Vakuum in die Kammer gesaugt wird; und eine Vorrichtung zum Anlegen einer negativen Ladung an die Nadel vorgesehen ist, um Elektronen dazu zu bringen, sich von der Nadel zum zweiten Abschnitt zu bewegen; die durch die Probe gedämpfte Strahlung auf das geschlossene Ende der Nadel auftrifft, um Photoelektronen zu erzeugen, die radial weg von der Nadel beschleunigt werden, um an der Nadelspitze ein Elektronenbild der Probe zu erzeugen, das durch die radiale Beschleunigung vergrößert wird; und eine Vorrichtung zum Empfangen und/oder Aufnehmen eines Elektronenbildes aus den Photoelektronen vorgesehen ist.

2. Mikroskop nach Anspruch 1, dadurch gekennzeichnet, daß die Strahlungsquelle eine Impulsstrahlung erzeugt.

3. Mikroskop nach Anspruch 1 oder 2, dadurch gekennzeichnet, daß die Strahlungsquelle entweder weiche Röntgenstrahlen, vorzugsweise unmittelbar oberhalb einer Absorptionskante von Atomen in der Probe, erzeugt, oder daß die Strahlungsquelle eine Strahlung mit optischer Wellenlänge erzeugt.

4. Mikroskop nach einem der vorhergehenden Ansprüche, dadurch gekennzeichnet, daß der zweite Abschnitt der Kammer einen Bildverstärker aufweist.

5. Mikroskop nach einem der vorhergehenden Ansprüche, dadurch gekennzeichnet, daß das Vakuum im Bereich von $10^{-2}$ bis $10^{-6}$ Torr liegt.

6. Mikroskop nach einem der vorhergehenden Ansprüche, gekennzeichnet durch die Verwendung einer lebenden Probe.

7. Mikroskop nach einem der vorhergehenden Ansprüche, dadurch gekennzeichnet, daß die Nadel eine dünne Beschichtung (24) aus Iridium aufweist.

8. Abstützung für eine Probe, die in ein Mikroskop eingeführt werden soll, das eine Kammerwand zum Empfangen und/oder Aufnehmen eines Elektronenbildes aufweist, wobei die Abstützung abhängig von Strahlung, die durch die Probe gedämpft wird und auf die Abstützung einwirkt, der Erzeugung von Photoelektronen dient, dadurch gekennzeichnet, daß die Abstützung eine hohle Nadel ist, die angrenzend an ein Ende eine Öffnung und angrenzend an das andere Ende einen Verschluß aufweist, der Verschluß aus Materialien hergestellt ist, die ansprechend auf einfallende Strahlung Photoelektronen erzeugen, und daß der Verschluß der Nadel eine Stelle zum Aufnehmen der Probe auf der Innenseite der Nadel angrenzend an den Verschluß festlegt, wodurch die Strahlung, die auf die Probe auf der Innenseite der Nadel auftrifft, ein Kontakt-Elektronenbild der Probe erzeugt und das Bild auf die Kammerwand projiziert.

9. Abstützung nach Anspruch 8, dadurch gekennzeichnet, daß die Nadel einen Nadelpunktradius in der Größenordnung von 1 - 5 µm aufweist.

10. Abstützung nach Anspruch 8 oder 9 dadurch gekennzeichnet, daß die Nadel eine schützende und verstärkende Beschichtung (26) aus Materialien aufweist, die fähig sind, die Nadel vor Luftdruck zu schützen.

**Revendications**

1. Microscope ayant une source de radiation, ladite radiation agissant sur un échantillon pourvu d'un support, ladite radiation étant atténuée par une image de contact dudit échantillon, ledit support présentant une aiguille creuse ayant une ouverture contiguë à une extrémité, une fermeture contiguë à l'autre extrémité et fabriqué en un matériau qui produit une réponse photoélectronique à la radiation incidente, ladite aiguille creuse présentant une intérieure, contiguë à la fermeture, pour recevoir ledit échantillon; une chambre pour la réception de l'aiguille à une portion et pour la réception et/ou l'enregistrement d'une image électronique à une deuxième portion, ayant une pompe à vide permettant de faire un vide à l'intérieur de ladite chambre; des moyens pour appliquer une charge négative à l'aiguille sont pourvus pour provoquer le déplacement des électrons de l'aiguille à la deuxième portion; ladite radiation atténuée par ledit échantillon, frappe l'extrémité fermé de l'aiguille pour produire des photoélectrons qui sont accélérés radialement les éloignant de ladite aiguille afin de produire une image électronique dudit échantillon à l'extrémité de ladite aiguille grossie par ladite accélération radiale; et des moyens pour la réception et/or l'enregistrement d'une image électronique desdits photoélectrons.

2. Microscope selon la revendication 1, caractérisé en ce que ladite source de radiation fournit de la radiation pulsée.

3. Microscope selon les revendication 1 ou 2, caractérisé en ce que ladite source de radiation fournit ou des rayons X doux, de préférence au dessus d'une arête d'absorption des atomes dudit échantillon, ou ce que ladite source de radiation fournit de la radiation de longueur d'onde optique.

4. Microscope selon l'une ou l'ensemble des revendications précédentes, caractérisé en ce que ladite deuxième portion comprend un intensificateur d'image.

5. Microscope selon l'une ou l'ensemble des revendications précédentes, caractérisé en ce que le vide se situe entre $10^{-2}$ et $10^{-6}$ torr.

6. Microscope selon l'une ou l'ensemble des revendications précédentes, caractérisé par l'utilisation d'un échantillon vivant.

7. Microscope selon l'une ou l'ensemble des revendications précédentes, caractérisé en ce que ladite aiguille comprend une couche fine (24) en iridium.

8. Support pour un échantillon qui est prévu pour être introduit dans une microscope ayant une paroi de chambre pour la réception et/ou enregistrement d'une image électronique, ledit support étant pour la production de photoélectrons dépendant de la radiation atténuée par ledit échantillon et frappant ledit support caractérisé en ce que ledit support est une aiguille creuse ayant une ouverture contiguë à une extrémité et une fermeture contiguë à l'autre, ladite fermeture étant composée de matériaux qui produisent des photoélectrons qui répondent à la radiation incidente, et que ladite fermeture de l'aiguille définit un site pour recevoir l'échantillon à l'intérieur de l'aiguille contiguë à la fermeture, la radiation qui frappe ledit échantillon à l'intérieur de l'aiguille produit une image électronique de contact dudit échantillon et projette ladite image sur la paroi de la chambre.

9. Support selon la revendication 1, caractérisé en ce que ladite aiguille présente un rayon de point d'aiguille de l'ordre de 1 à 5 microns.

10. Support selon les revendications 8 ou 9, caractérisé en ce que ladite aiguille présente une couche protectrice et renforçante(26), fabriqué en matériaux suffisant pour protéger ladite aiguille de la pression atmosphérique.

FIG.__1.

FIG.__3A. PRIOR ART

FIG.__3B. PRIOR ART

FIG.__3C.

FIG.__3D.

FIG._2.

EP 0 322 419 B1

*FIG._4A.*

*FIG._4B.*

*FIG._4C.*

*FIG._4D.*

12